# EUROPEAN PATENT APPLICATION

(11) **EP 3 499 585 A1**
(43) Date of publication of application: **19.06.2019**
(21) Application number: 17207491.6
(22) Date of filing: 14.12.2017
(51) Int. Cl.: H01L 31/049, B32B 37/10, B30B 5/04

(54) **PROCESS FOR ANNEALING A CONDUCTIVE BACKSHEET**

(71) Applicant: DSM IP Assets B.V., 6411 TE Heerlen (NL)
(72) Inventor: The designation of the inventor has not yet been filed
(74) Representative: DSM Intellectual Property

(57) **Abstract**

The present invention relates to a process for annealing an electro- conductive backsheet comprising a metal layer, an adhesive system and at least one polymeric layer whereby the electro- conductive backsheet is processed at a temperature in the range from 60°C-200°C under controlled pressure and tension, where after the electro-conductive backsheet is cooled under controlled pressure and tension. Preferably the electro-conductive backsheet is processed at a temperature in the range from 90°C-150°C. The adhesive system comprises at least an adhesive polymeric layer with reactive groups. Preferably the adhesive system is a dual adhesive system. Preferably the dual adhesive system comprises two adhesive polymeric layers from which at least one polymeric layer comprises reactive groups. The electro- conductive backsheet may be annealed with a double belt press or via calendaring. The invention further relates to an electro- conductive backsheet obtainable by the process of the present invention and to the use of the electro- conductive backsheet in PV modules.

## Description

The present invention relates to a process for annealing an electro-conductive backsheet comprising a metal layer, an adhesive system and at least one polymeric layer whereby the electro- conductive backsheet is processed at a temperature in the range from 60°C-200°C under controlled pressure and tension, where after the electro-conductive backsheet is cooled under controlled pressure and tension. The invention further relates to an electro- conductive backsheet obtainable by the process according to the present invention. The invention also relates to a photovoltaic module comprising the electro- conductive backsheet.

The object of the present invention is to provide an electro-conductive backsheet with improved adhesive properties. A further object of the present invention is to provide a photovoltaic module comprising the electro-conductive backsheet with improved durability.

The objects have been achieved in that a process is provided for annealing an electro- conductive backsheet comprising a metal layer, an adhesive system and at least one polymeric layer whereby the electro- conductive backsheet is processed at a temperature in the range from 60°C-200°C under controlled pressure and tension, where after the electro-conductive backsheet is cooled under controlled pressure and tension.

It has surprisingly been found that the electro- conductive backsheet provides better durability as a result of improved adhesion. It has moreover been found that a photovoltaic module comprising the electro- conductive backsheet shows improved performance in thermocycling testing. During thermocycling testing the degradation of the power output of the PV module is monitored during 200 cycles between -40°C and 85°C. It has been found that the degradation is reduced from above 10% to below 1% if the electro- conductive backsheet is annealed before it is used in the PV module.

The electro- conductive backsheet may be annealed in the double belt press or via calendering. The annealing processes usually take place at a temperature in the range from 60°C-200°C under controlled pressure and tension. Preferably the electro- conductive backsheet is annealed in a double belt press at a temperature in the range from 90-°C-150°C, more preferably at a temperature in the range from 100°C-140°C under controlled pressure under controlled pressure. Even more preferably the electro- conductive backsheet is annealed in a double belt press at a temperature in the range from 120°C-130°C under controlled pressure. In case that the electro- conductive backsheet is annealed in the double belt press, the electro-conductive backsheet is preferably processed in a heating zone of 1 to 5 meter, followed by a cooling zone of 1 to 5 meter. A double belt press is known in the art and for example disclosed in EP-A-2601028.

The electro- conductive backsheet comprises an adhesive system comprising at least one adhesive polymeric layer comprising reactive groups. Preferably, the adhesive system is a dual adhesive system. The dual adhesive system comprises two adhesive polymeric layers from which at least one polymeric layer comprises reactive groups. Examples of reactive groups are maleic anhydride, epoxy, acrylic acid, methacrylic acid, amine, hydroxyl, silane or isocyanate. The adhesive system may comprise a thermoplastic or thermoset polymer. A thermoplastic polymer is a polymer that becomes pliable or moldable above a specific temperature and solidifies upon cooling. Thermoplastics differ from thermosetting polymers in that thermosetting polymers form irreversible chemical bonds during a curing process. Thermosets do not melt, but decompose and do not reform upon cooling. Thermoplastic polymer layers are preferred. More preferably the adhesive system comprises a polyolefine adhesive layer. Still more preferably the adhesive system comprises two adhesive layers, one layer being a modified polyethylene and a linear low-density polyethylene adhesive layer whereby the ratio in terms of mass of the modified polyolefin with respect to the mass of the linear low-density polyethylene is 43% or greater and a second adhesive layer comprising a high melt strength polyethylene TOSOH-HMS (manufactured by Tosoh Corporation). As the modified polyolefin, for example, it is possible to use ADMER (registered trademark, manufactured by Mitsui Chemicals) suitably. The thickness of the adhesive layer is preferably between 5 µm-100 µm

The electro- conductive backsheet comprises a metal layer including but not limited to copper, aluminium, tin, silver or nickel, or mixtures of two or more thereof or alloys of two or more thereof. Preferably the metal used as metal layer is copper (Cu). The metal layer is preferably patterned before the annealing process takes place. Such pattern can be obtained through known patterning technologies. Examples of known patterning technologies given as an indication without being limiting are mechanical milling, chemical etching, laser ablation and die cutting. Laser ablation, mechanical milling or die cutting are preferably used.

Beside the metal layer and the adhesive layer, the electro- conductive backsheet comprises at least one polymeric layer. Examples of usefull polymers are thermoplastic polymers such as polyolefines, polyamides, polyesters, fluorinated polymers, or combinations thereof. Preferably the polymers are selected from polyolefins and/ or polyamides and/or polyesters.

Examples of polyamides are PA46, PA6, PA66, PA MXD6, PA610, PA612, PA10, PA810, PA106, PA1010, PA1011, PA1012, PA1210, PA1212, PA814, PA1014, PA618, PA512, PA613, PA813, PA914, PA1015, PA11, PA12. The naming of the polyamides corresponds to the international standard, the first number(s) giving the number of carbon atoms of the starting diamine and the last number(s) the number of carbon atoms of the dicarboxylic acid. If only one number is mentioned, this means that the starting material was aminocarboxylic acid or the lactam derived therefrom. Reference is made to H. Domininghaus, Die Kunststoffe and ihre Eigenschaften [The polymers and their properties], pages 272 ff., VDI-Verlag, 1976.) Also suitable are polyphthalamides or PPAs such as PA4T, PA4T6T, PA66/6T, PA6/6T, PA6T/MPMDT (MPMD stands for 2-methylpentamethylenediamine), PA9T, PA10T, PA11T, PA12T, PA14T and copolycondensates of these latter types with an aliphatic diamine and an aliphatic dicarboxylic acid or with aminocarboxylic acid or a lactam. Blends of the above stated polyamides may also be used.

Examples of polyolefins are ethylene or propylene homo-and copolymers such as polyethylene or polypropylene. The polypropylene may in principle be of any customary commercial polypropylene type, such as an isotactic or syndiotactic homo-or copolymer. The copolymer can be a random-or block-copolymer. The polyolefins can be prepared by any known process, as for example by the Ziegler-Natta method or by means of metallocene catalysis. It is possible to combine the polyolefins with an impact-modifying component, for example a rubber such as EPM rubber or EPDM rubber or SEBS. Optionally the polyolefins are functionalized with functional groups such as maleic anhydride grafted polyethylene or maleic anhydrate grafted polypropylene.

Also flexible polypropylene (FPP) being mechanical or reactor blends of polypropylene (homo or copolymer) with EPR rubber (ethylene propylene rubber) are possible. Examples of such reactor blends are Hifax CA 10 A, Hifax CA 12, Hifax CA7441A, supplied by LyondellBasell, or thermoplastic vulcanisates blends like Santoprene. Such thermoplastic vulcanisates are based on blend of polypropylene with EPDM rubber which are partly crosslinked. Examples of mechanical blends are blends of polypropylene with elastomers such as Versify 2300.01 or 2400.01 (supplied by Dow) Another type of mechanical blend is polypropylene with LLDPE (linear low densitiy polyethylene) or VLDPE (very low-density polyethylene) plastomers (like Queo 0201 or Queo 8201 supplied by Borealis Plastomers), or copolymers of Ethylene with a polar co-monomer such as vinyl acetate or alkyl acrylates.

Examples of thermoplastic polyesters include linear thermoplastic polyesters such as polyethylene terephthalate (PET), polypropylene terephthalate (PPT), polybutylene terephthalate (PBT), polyethylene 2,6-naphthalate (PEN), polypropylene 2,6-naphthalate (PPN) and polybutylene 2,6-naphthalate (PBN).

Examples of fluorinated polymers are polyvinylfluoride (PVF), polyvinylidene fluoride (PVDF) or polytetrafluoroethylene (PTFE).

The polymeric layers may comprise additives known the art. Preferably the polymers comprise at least one additive selected from UV stabilizers, UV absorbers, anti-oxidants, thermal stabilizers and/or hydrolysis stabilizers. When such additives stabilizers are used, a polymeric layer may comprise from 0.05-10 wt.% more preferably from 1-5 wt.%, based on the total weight of the polymer.

White pigments such as talc, mica, TiO2, ZnO or ZnS may be added to the to one or more polymeric layers of the multilayer film to increase backscattering of sunlight leading to increased efficiency of the PV module. Black pigments such as carbon black or iron oxide may be added for esthetic reasons but also for UV adsorption.

The present invention further relates to the electro- conductive backsheet obtainable by the process according to the present invention. The electro-conductive backsheet shows better adhesive properties after the annealing process. Moreoverif the electro-conductive backsheet is used in a photovoltaic module (PV) the comprising the electro- conductive backsheet, the PV module performs better and shows improved performance in thermocycling testing. During thermocycling testing the degradation of the power output of the PV module is monitored during 200 cycles between -40°C and 85°C. It has been found that the degradation is reduced from above 15% to below 1% if the electro- conductive backsheet is annealed before it is used in the PV module.

The electro- conductive backsheet may also comprise more thermoplastic polymeric layers having different functionalities such as a functional polymeric layer, a weather-resistant polymeric layer, a structural polymeric layer and optionally one or more bonding layers.

The functional layer is usually facing the cells and preferably comprises a polyethylene (PE) alloy such as a blend of polyethylene and an ethylene copolymer. Preferably the polyethylene comprises polar co-monomers such as vinyl acetate, acrylic and methacrylic ester such as methylacrylate, ethylacrylate, butylacrylate or ethylhexylacrylate. The functional layer may comprise inorganic fillers or additives. Preferred inorganic fillers are titanium dioxide or zinc oxide. The functional layer may comprise from 0.05-20 wt.% inorganic filler and or additives, more preferably to 5-10 wt.% inorganic filler and/or additives based on the total weight of the polymers in the layer.

The weather-resistant layer is usually the outer layer of the electro-conductive backsheet. It may for example comprise a polyamide or a F-containing polymer such as PTFE, PVF or PVDF. The polyamide is preferably chosen from PA46, PA6, PA66, PA MXD6, PA410, PA610, PA612, PA10, PA810, PA106, PA1010,_{[DF1]} PA1011, PA1012, PA1210, PA1212, PA814, PA1014, PA618, PA512, PA613, PA813, PA914, PA1015, PA11 or PA12. The weather-resistant layer may further comprise titanium dioxide or barium sulfate, a UV-stabilizer and a heat stabilizer.

The bonding layer(s) for example comprise polyurethane, acrylate based polymers or polyolefines. Examples of polyolefines are maleic anhydride grafted polyolefine such as maleic anhydride grafted polyethylene or polypropylene, an ethylene-acrylic acid copolymer or an ethylene-acrylic ester-maleic anhydride terpolymer. Preferably, the bonding layer(s) comprise maleic anhydride grafted polyolefine such as a maleic anhydride grafted polyethylene or a maleic anhydrate grafted polypropylene.

The structural reinforcement layer for example comprises an engineering plastic such as polypropylene or an alloy of polypropylene or modified polypropylene, a FPP, a polyester such as PET or a polyamide as described above.

All the different polymeric layers in the electro-conductive backsheet may comprise inorganic fillers or additives. Preferred inorganic fillers are titanium dioxide, zink oxide or talc. The layers may comprise from 0.05-20 wt.% inorganic filler and or additives, more preferably from 5-15 wt.% inorganic filler and/or additives based on the total weight of the polymers in the different layers.

Preferably the electro-conductive backsheet comprises between 1-5 polymeric layers, more preferably between 2-4 polymeric layers.

The electro-conductive backsheet may be manufactured as disclosed in below embodiment. The electro-conductive backsheet can be manufactured via the following steps:
(a) providing the (patterned) metal layer
(b) providing an adhesive system
(c) providing one or more polymeric layer(s)
(d) co-extrusion/lamination or adhesion of the metal layer, adhesive system and the polymeric layers.
(e) Annealing the electro- conductive backsheet at a temperature in the range from 60°C-200°C under controlled pressure and tension,
(f) Cool the electro-conductive backsheet under controlled pressure and tension.
The process may comprise a patterning step. Such pattern can be obtained through known patterning technologies. Examples of known patterning technologies given as an indication without being limiting are mechanical milling, chemical etching, laser ablation and die cutting. Laser ablation, mechanical milling or die cutting are preferably used.

The present invention further relates to a photovoltaic module comprising the electroconductive backsheet according to the present invention. A photovoltaic module (abbreviated PV module) comprises at least the following layers in order of position from the front sun-facing side to the back non-sun-facing side: (1) a transparent pane (representing the front sheet), (2) a front encapsulant layer, (3) a solar cell layer, (4) a back encapsulant layer, and (5) the electro-conductive back-sheet according to the present invention, representing the rear protective layer of the module.

The front sheet is typically a glass plate or especially for flexible modules a layer of fluorinated polymers like ETFE (ethylene tetrafluorethylene) or PVDF (polyvinylidene fluoride).

The front and back encapsulant used in solar cell modules are designed to encapsulate and protect the fragile solar cells. The "front side" corresponds to a side of the photovoltaic cell irradiated with light, i.e. the light-receiving side, whereas the term "backside" corresponds to the reverse side of the light-receiving side of the photovoltaic cells.

Suitable polymer materials for solar cell encapsulants typically possess a combination of characteristics such as high impact resistance, high penetration resistance, good ultraviolet (UV) light resistance, good long term thermal stability, adequate adhesion strength to glass and/or other rigid polymeric sheets, high moisture resistance, and good long-term weather ability. Currently, ethylene/vinyl acetate copolymers are the most widely used encapsulants.

The photovoltaic module comprising the electro-conductive backsheet according to the present invention surprisingly provides more stability and durability. Moreover, the photovoltaic module shows power output which remains stable over time (1000-2000 hours)

The present invention will now be described in detail with reference to the following non-limiting examples which are by way of illustration only.

## Claims

1. Process for annealing an electro- conductive backsheet comprising a metal layer, an adhesive system and at least one polymeric layer whereby the electro-conductive backsheet is processed at a temperature in the range from 60°C-200°C under controlled pressure and tension, where after the electro-conductive backsheet is cooled under controlled pressure and tension.

2. Process for annealing an electro- conductive backsheet according to claim 1 whereby the electro-conductive backsheet is processed at a temperature in the range from 90°C-150°C.

3. Process for annealing an electro-conductive backsheet according to claim 1 wherein the adhesive system comprises at least an adhesive polymeric layer with reactive groups.

4. Process for annealing an electro-conductive backsheet according to any one of the claims 1 whereby the adhesive system is a dual adhesive system.

5. Process for annealing an electro-conductive backsheet according to claim 4 whereby the dual adhesive system comprises two adhesive polymeric layers from which at least one polymeric layer comprises reactive groups.

6. Process for annealing an electro-conductive backsheet according to claims 3 or 5 whereby the reactive groups are selected from the group consisting of maleic anhydride, epoxy, acrylic acid, methacrylic acid, cyanate.

7. Process for annealing an electro-conductive backsheet according to any one of the claims 3 or 4 wherein the adhesive system comprises a thermoplastic or thermoset polymeric layer.

8. Process for annealing an electro-conductive backsheet according to claim 1 whereby the metal layer is patterned.

9. Process for annealing an electro-conductive backsheet according to claim 1 or 8 whereby the metal layer is copper.

10. Process for annealing an electro- conductive backsheet according to claim 1 whereby the an electro- conductive backsheet comprises at least one thermoplastic polymer layer chosen from the group selected of polyolefines, polyamides, polyesters or fluorinated polymers.

11. Process for annealing an electro- conductive backsheet according to any one of the claims 1-10 whereby a double belt press or a calender is used.

12. Process for annealing an electro- conductive backsheet according to claim 11 whereby a double belt press is used under continuous pressure.

13. Process for annealing an electro- conductive backsheet according to claim 12 whereby the electro- conductive backsheet is processed in a heating zone of 1 to 5 meter.

14. Process for annealing an electro- conductive backsheet according to claims 12-13 whereby the electro- conductive backsheet is processed in a cooling zone of 1 to 5 meter.

15. Process for annealing an electro- conductive backsheet according to claim 11 whereby a calendar is used under continuous tension.

16. Electro- conductive backsheet obtainable by the process according to any one of the claims 1-15.

17. Photovoltaic module comprising the electro- conductive backsheet according to claim 16.
